**Europäisches Patentamt**

**European Patent Office**

**Office européen des brevets**

(19)

(11) Veröffentlichungsnummer: **0 066 010**
**B1**

(12)

# EUROPÄISCHE PATENTSCHRIFT

(45) Veröffentlichungstag der Patentschrift:
**10.10.84**

(21) Anmeldenummer: **81109143.8**

(22) Anmeldetag: **28.10.81**

(51) Int. Cl.³: **H 04 B 3/44, H 03 H 5/02**

(54) **Frequenzweiche zur Trennung eines Signal- und eines Versorgungsstromes.**

(30) Priorität: **03.06.81 DE 3122084**

(43) Veröffentlichungstag der Anmeldung:
**08.12.82 Patentblatt 82/49**

(45) Bekanntmachung des Hinweises auf die Patenterteilung:
**10.10.84 Patentblatt 84/41**

(84) Benannte Vertragsstaaten:
**AT CH FR IT LI SE**

(56) Entgegenhaltungen:
**EP - A - 0 014 969**
**DE - A - 1 911 960**
**DE - B - 1 272 466**
**FR - A - 2 353 181**

**FREQUENZ, Band 28, Nr. 12, 1974, Seiten 326-333, Berlin, DE. W. PETERS: "Stromversorgungsweichen für ferngespeiste Trägerfrequenzzwischenverstärker"**

(73) Patentinhaber: **Siemens Aktiengesellschaft, Berlin und München Wittelsbacherplatz 2, D-8000 München 2 (DE)**

(72) Erfinder: **Wendt, Peter, Dipl.-Ing., Badstrasse 4, D-8000 München 70 (DE)**

## Beschreibung

Die Erfindung betrifft eine Frequenzweiche zur Trennung eines Signalstromes und eines Versorgungsstromes, zum Einsatz in ferngespeisten Zwischenregeneratoren oder Verstärkern breitbandiger Übertragungssysteme mit Koaxialkabelstrecken, die eine hohe Umlaufdämpfung bei hohen Frequenzen aufweist, mit einer eingangs- und/oder ausgangsseitigen Drosselanordnung für die Stromversorgung und einem Kondensator, der einen der beiden Stromversorgungsanschlüsse des Regenerators bzw. Verstärkers mit dessen Bezugspotential verbindet.

Aus der DE-PS 1 272 466 ist eine Frequenzweiche der eingangs genannten Art bekannt, die aus in Reihe geschalteten Hoch- und Tiefpaßfiltern besteht, insbesondere für die Stromversorgung ferngespeister Leitungsverstärker von breitbandigen Trägerfrequenzsystemen verwendet wird und unter Verwendung von Koaxialdrosseln aufgebaut ist. Bei diesen Koaxialdrosseln setzen die beiden Wicklungen dem gegensinnig durchfließenden Signalstrom einen sehr geringen Widerstand entgegen, während sie den jeweils nur eine Wicklung durchfließenden Störströmen einen sehr hohen Widerstand entgegensetzen. Für die Verbindung zwischen dem Bezugspotential des Verstärkers und dem Massepotential des Koaxialkabelaußenleiters sind Kondensatoren vorgesehen, die bei hohen Frequenzen eine merkliche Induktivität aufweisen. Diese Induktivität verschlechtert die Koppelwirkung des Kondensators, sie ergibt sich aus der Zuleitungsinduktivität des Kondensators und der durch die Hochspannungsfestigkeit bedingten Bauform und ist deshalb nicht ohne weiteres beliebig zu verringern. Durch die verschlechterte Verbindung der beiden Massepotentiale ergibt sich eine Verschlechterung der Umlaufdämpfung, also eine erhöhte Rückwirkung des Ausgangssignals des Verstärkers auf dessen Eingang. Unter Umlaufdämpfung wird dabei die Dämpfung zwischen den ausgangsseitigen Klemmenpaaren und den eingangsseitigen Klemmenpaaren bezeichnet. Durch zusätzlich vorgesehene Leitungsdrosseln soll in diesem Falle die Umlaufdämpfung wiederum erhöht werden, hierbei ergibt sich aber eine weitere Grenze durch die bei höheren Induktivitäten auftretende störende Streuinduktivität der Leitungsdrosseln.

Aus der Zeitschrift »Frequenz« 28, 1974, Seiten 326 bis 333, insbesondere Bild 15, ist eine weitere derartige Anordnung bekannt, bei der auf ein Koaxialkalbel nacheinander Ferritringe und Hochspannungskondensatoren aufgebracht sind und die ganze Anordnung von einem in leitender Verbindung stehenden rohrförmigen Gehäuse umgeben ist. Bei Verwendung von Koaxialkabeln ergibt sich dabei aber eine aufwendige und schwierige Kontaktierung der Kondensatoren an der Innenwandung des rohrförmigen Gehäuses und an dem Koaxialkabelaußenleiter. Im Hinblick auf die hohen Signalfrequenzen ist die vorgeschlagene Kontaktierung mittels Federn nicht einsetzbar, außerdem ist bei dem mit den Kondensatoren und Ferritringen verbundenen Kabelstück eine besonders hochwertige Abschirmung erforderlich.

Aus der DE-OS 26 23 412 ist ein ferngespeister, zwischen einer eingangsseitigen und einer ausgangsseitigen, über eine Außenleiterverbindung miteinander verbundenen Leitung angeordneter Zwischenverstärker für insbesondere koaxiale Nachrichtenübertragungsstrecken bekannt, bei dem die Außenleiterverbindung und ein Speisespannungsanschluß, der zugleich ein wechselspannungsmäßiges Bezugspotential hat, kapazitiv verbunden sind. Auch bei dieser Anordnung ist wenigstens ein Kondensator zwischen dem Massepotential des Koaxialkabelaußenleiters und dem Bezugspotential des Zwischenverstärkers vorgesehen, so daß sich bei höheren Frequenzen Probleme hinsichtlich der Verkopplung von Eingangskreis und Ausgangskreis über die Masseverbindungen ergeben. Zur Erhöhung der Umlaufdämpfung wird der Verstärker in wenigstens zwei Teilverstärker aufgeteilt, wobei die beiden Teilverstärker über jeweils einen zwischen dem Bezugspotential des Teilverstärkers und dem Außenleiterpotential des Koaxialkabels liegenden Kondensator entkoppelt sind; außerdem sind die Speisespannungseingänge der Teilverstärker hochfrequenzmäßig voneinander entkoppelt. Zur Erhöhung der Umlaufdämpfung ist zusätzlich eine Leitungsdrossel vorgesehen, die das Nutzsignal vom eingangs- zum ausgangsseitigen Teilverstärker überträgt und dabei Störsignale unterdrückt. Eine sichere Unterdrückung der Störsignale ergibt sich aber nur dann, wenn die Durchführung durch die auf dem Potential des Kabelaußenleiters befindliche Außenkammertrennwand zwischen den beiden Teilverstärkern eine hohe Kapazität aufweist, also als hochspannungsfester Durchführungskondensator ausgebildet ist. Durch diese zusätzlichen Durchführungskondensatoren, die für jede Leitungsverbindung zwischen den beiden Teilverstärkern vorzusehen sind, ergibt sich aber insgesamt ein hoher Aufwand bei gleichzeitig umständlichem mechanischen Aufbau der Verstärkeranordnung. Außerdem ergibt sich durch die Parallelschaltung der einzelnen Leitungsdrosseln insgesamt wiederum eine Verringerung der wirksamen Induktivität und damit eine Verringerung der Umlaufdämpfung. Die Verkopplung zwischen den beiden Verstärker- bzw. Regeneratorteilen erfolgt dabei über Leitungen, die in einem felderfüllten Raum verlaufen, so daß einerseits die Möglichkeit der Einstreuung von Störungen besteht und andererseits die erforderliche allseitige Abschirmung Einfluß auf die Verstärker- bzw. Regeneratoreigenschaften hat.

Die Aufgabe der Erfindung besteht darin, bei einer Anordnung der eingangs geschilderten Art eine problemlose Verbindung zwischen den einzelnen Baugruppen und damit einen einfachen mechanischen Aufbau zu ermöglichen, eine hohe Sicherheit gegen äußere Störungen zu gewährleisten, eine hohe Umlaufdämpfung bis zu etwa 140 dB und bis zu Frequenzen von etwa 800 MHz zu erreichen und dabei keine wesentliche Veränderung der Funktion der Frequenzweiche zu bewirken.

Die Aufgabe wird erfindungsgemäß dadurch gelöst, daß eine homogene Leitung mit einem Wellenwiderstand entsprechend dem des Anschlußkabels vorgesehen ist, die auf der einen Seite mit Innen- und Außenleiter mit den entsprechenden Leitern des Anschlußkabels verbunden ist, und deren Innenleiter auf der anderen Seite mit einem Signalanschluß des Regenerators bzw. Verstärkers, gegebenenfalls über einen Kondensator, verbunden ist, daß der Außenleiter der homogenen Leitung an der Verbindungsstelle mit dem Anschlußkabel möglichst niederohmig und an seinem Ende wenigstens kapazitiv mit dem Innenleiter einer inhomogenen Leitung verbunden ist, daß in der inhomogenen Leitung Abschnitte gegenüber den Anschlußkabeln sehr niedrigen oder hohen Wellenwiderstandes abwechseln, daß der dem Anschlußkabel benachbarte Anschluß des Außenleiters der inhomogenen Leitung mit einer Abschirmung in leitender Verbindung steht und daß der andere Anschluß des Außenleiters mit dem Bezugspotential des Regenerators bzw. Verstärkers verbunden ist.

Die erfindungsgemäße Frequenzweiche bietet neben dem Vorteil des vergleichsweise geringen Aufwandes auch den Vorteil der vergleichsweise geringen Abmessungen, die im Hinblick auf die notwendige lückenlose Abschirmung und geringere parasitäre Impedanzen wesentlichen Einfluß auf die erzielten elektrischen Eigenschaften hat.

Eine wegen ihres einfachen Aufbaues vorteilhafte Weiterbildung der erfindungsgemäßen Frequenzweiche ergibt sich dadurch, daß die homogene Leitung durch einen Teil des Anschlußkabels gebildet ist. Dadurch werden auf der einen Seite mögliche Stoßstellen vermieden und auf der anderen Seite ergibt sich ein entsprechend einfacher Aufbau.

Bei einem gesamten Aufbau der Anordnung in Streifenleitungstechnik ist eine Variante der Erfindung zweckmäßig, bei der die homogene Leitung durch eine Streifenleiteranordnung gebildet ist.

Ein vorteilhaft einfacher Aufbau ergibt sich unter Verwendung eines Rohrkörpers als mechanischer Träger dadurch, daß die inhomogene Leitung durch einen hochspannungsfesten Rohrkörper gebildet ist, durch den die homogene Leitung geführt ist, daß der Rohrkörper aus einem Material hoher Dielektrizitätskonstante geformt ist, daß der Rohrkörper innen eine durchgehende Metallisierung aufweist, die den Innenleiter der inhomogenen Leitung darstellt, daß der Rohrkörper eine äußere Metallisierung aufweist, die durch wenigstens einen Ferritring unterbrochen ist und die den Außenleiter der niederohmigen Abschnitte der inhomogenen Leitung darstellt und daß ein mit dem Außenleiter der niederohmigen Abschnitt in leitender Verbindung stehendes, den Rohrkörper umfangsmäßig für wenigstens einen Teil seiner Länge umschließendes Abschirmgehäuse vorgesehen ist, das den Außenleiter der hochohmigen Abschnitte der inhomogenen Leitung darstellt. Von besonderem Vorteil ist dabei, daß das durch den Rohrkörper geführte Kabelstück keine besonders dichte Abschirmung besitzen muß.

Weitere zweckmäßige Ausbildungen der erfindungsgemäßen Frequenzweiche sind den Patentansprüchen 5 bis 9 zu entnehmen.

Die Erfindung soll im folgenden anhand der Zeichnung näher erläutert werden. In der Zeichnung zeigt

Fig. 1 einen Regenerator für digitale Signale mit einer eingangs- und einer ausgangsseitigen Frequenzweiche,

Fig. 2 den konstruktiven Aufbau des wesentlichen Teils der erfindungsgemäßen Frequenzweiche und

Fig. 3 einen Schnitt durch die erfindungsgemäße Frequenzweiche.

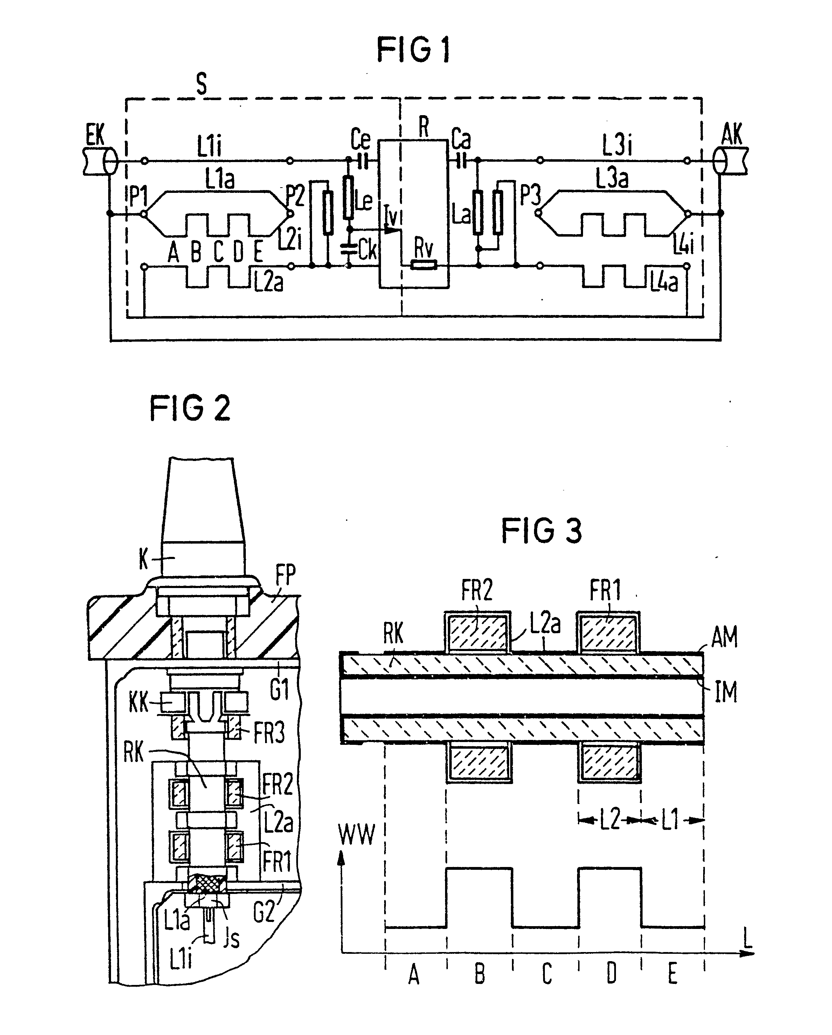

In der Fig. 1 ist die Regeneratoranordnung mit den Frequenzweichen zwischen dem eingangsseitigen Anschlußkabel EK und dem ausgangsseitigen Anschlußkabel AK angeordnet. Ein Abschnitt des eingangsseitigen Anschlußkabels, das als Koaxialkabel ausgebildet ist, bildet die erste homogene Leitung L1, deren Innenleiter am Kabelende mit dem einen Anschluß eines Eingangskondensators Ce und einer eingangsseitigen Stromversorgungsdrossel Le verbunden ist. Das als homogene Leitung L1 wirksame Kabelstück ist durch einen in der Fig. 3 näher dargestellten Rohrkörper durchgesteckt und mit dessen Innenmetallisierung auf der Kabelseite an dem in der Zeichnung dargestellten Punkt P1 durch eine Klemmverbindung möglichst niederohmig verbunden. Am regeneratorseitigen Ende des Rohrkörpers ist die Verbindung zwischen Koaxialkabelaußenleiter L1a und Innenmetallisierung des Rohrkörpers L2i am Punkte P2 kraftschlüssig verbunden. An diesem Punkte P2 ist eine besonders niederohmige Verbindung nicht erforderlich, es reicht eine kapazitive Verbindung aus, die innerhalb des Rohrkörpers wesentlich leichter als eine Lötverbindung herzustellen ist.

Der Rohrkörper trägt außen an einigen Stellen eine Metallisierung und an anderen Ferritringe, insgesamt ergibt sich eine inhomogene Leitung mit gegenüber dem Wellenwiderstand des Anschlußkabels vergleichsweise sehr niederohmigen Leitungsstücken und hochohmigen Leitungsstücken. Der Rohrkörper ist in ein Abschirmgehäuse eingebettet, das zusammen mit den äußeren Metallisierungen des Rohrkörpers den Außenleiter L2a der inhomogenen Leitung darstellt; dieser Außenleiter ist an einer dem Punkte P1 benachbarten Stelle mit der Gehäuseabschirmung verbunden. An einer dem Punkte P2 benachbarten Stelle ist der Außenleiter mit dem Masseanschluß des Regenerators und damit mit einem Entkopplungskondensator Ck verbunden, der einen der beiden Stromversorgungsanschlüsse des Regenerators mit dessen Bezugspotential verbindet. Die eingangsseitige Drosselanordnung Le für die Stromversorgung ist mittels einer koaxialen Leitung aufgebaut, der Innenleiter der Leitung ist auf der einen Seite mit dem Innenleiter L1i der homogenen Leitung an derem regeneratorseitigen Ende verbunden. Außerdem ist der Innenleiter des die Drosselanordnung Le bildenden Kabels an dessen anderen Ende mit einem Stromversorgungsanschluß des Regenerators R verbunden. Der Außenleiter der Drosselanordnung Le ist beidseitig mit dem Massepunkt des Regenerators R verbunden.

Der Regenerator R erhält über den Eingangskondensator Ce die zu regenerierenden digitalen Signale, die er über den Ausgangskondensator Ca an die ausgangsseitige Frequenzweiche abgibt. Im Regenerator ist der Weg für den Versorgungsstrom Iv angedeutet, der durch den Verbraucherwiderstand Rv zum anderen Stromversorgungsanschluß des Regenerators und über eine ausgangsseitige Drosselanordnung La zum Innenleiter des ausgangsseitigen Anschlußkabels fließt. Die Außenleiter des eingangsseitigen und des ausgangsseitigen Kabels EK, AK sind direkt miteinander verbunden. Die ausgangsseitige Frequenzweiche mit einer weiteren homogenen Leitung L3 und einer weiteren inhomogenen Leitung L4 entspricht in ihrem Aufbau völlig dem der eingangsseitigen Frequenzweiche, so daß sich eine detaillierte Schilderung erübrigt.

Vom Innenleiter L1i gelangen die empfangenen digitalen Signale über den Eingangskondensator Ce zum Regenerator R, über die Drossel Le wird vom Innenleiter L1i der Versorgungsstrom abgezweigt und gelangt zum Stromversorgungsanschluß des Regenerators. Nach der Regenerierung des digitalen Signals wird dieses in der Sendestufe auf den für die Überbrückung des nächsten Regeneratorfeldes notwendigen Pegel verstärkt und an den nächsten Übertragungskabelabschnitt abgegeben. Bei Verwendung einer Stromsteuerung im Regenerator R kann dabei der Ausgangskondensator Ca entfallen.

Zur Abschirmung ist es weiterhin zweckmäßig, das Regeneratorgehäuse in zwei auf Regeneratorpotential befindliche Gehäuseteile zu unterteilen, wobei im linken Gehäuseteil das Übertragungssignal einen niedrigen und im rechten einen hohen Pegel hat. Die Verbindung zwischen den beiden Gehäusekammern kann dabei aber direkt, also ohne Verwendung einer Leitungsdrossel und auch ohne Verwendung von hochspannungsfesten Durchführungskondensatoren erfolgen. Durch eine unerwünschte Rückwirkung zwischen dem Ausgangsteil des Regenerators und dessem Eingangsteil entstehen zwar weiterhin eingangsseitig Störströme, diese fließen über den Punkt P1 in die als »Wellensumpf« wirksame inhomogene Leitung L2 mit ihren Abschnitten A, B, C, D, E stark unterschiedlichem Wellenwiderstandes; es ergibt sich dort jedoch eine bis an die Grenzen der Meßgenauigkeit heranreichende Dämpfung der Störströme.

Durch die ausgangsseitige Frequenzweiche mit ihrer inhomogenen Leitung L4 erfolgt zusätzlich eine erhebliche Dämpfung der rückkoppelnden Störspannungen, die ihre maximale Amplitude am Punkte P3, also am Eingang der weiteren inhomogenen Leitung L4 haben.

Vom weiteren Stromversorgungsanschluß des Regenerators R gelangt der Versorgungsstrom über die ausgangsseitige Drosselanordnung La zum Innenleiter L3i der weiteren homogenen Leitung L3 und damit zum Innenleiter des ausgangsseitigen Anschlußkabels. Auch die ausgangsseitige Drosselanordnung La ist mittels einer Koaxialleitung als Stichleitung aufgebaut.

In der Fig. 2 ist die konstruktive Ausbildung eines Regeneratoreingangsteils zusammen mit dem Kabelstutzen K dargestellt. Der Kabelstutzen K ist in eine Frontplatte FP eingesteckt, die am äußeren Regeneratorgehäuse G1 befestigt ist. Ein Kabelendstück ist durch eine Bohrung der Frontplatte und des Regeneratorgehäuses G1 durchgesteckt und reicht mit seinem Abschirmgeflecht, das dem Außenleiter L1a der ersten homogenen Leitung entspricht, in das innere Regeneratorgehäuse G2. Das Kabel ist mit einer Kabelklemme KK an der Innenseite des äußeren Regeneratorgehäuses G1 befestigt. Zwischen den beiden Regeneratorgehäusen G1 und G2 ist auf das Kabel ein Rohrkörper RK aufgeschoben, der innen durchgehend metallisiert ist, während er auf der Außenseite metallisierte Ringe enthält, die sich mit aufgeschobenen Ferritringen abwechseln. Der gesamte Rohrkörper RK ist umfangsmäßig von einem Gehäuse umgeben, das mit den Metallisierungen des Rohrkörpers in leitendem Kontakt steht und zusammen mit diesem den Außenleiter L2a der inhomogenen Leitung darstellt. Zwischen der Kabelklemme KK und dem Rohrkörper RK ist über ein freies Stück des Kabels ein dritter Ferritring aufgeschoben, der als Leitungsdrossel wirkt und eine Dämpfung von über den Kabelaußenleiter ankommenden Störspannungen bewirkt. Der in das innere Regeneratorgehäuse hineinreichende Teil des Kabels besteht aus einem Stück der Kabelisolierung Is als Spannungsschutz sowie dem Koaxialkabelinnenleiter L1i, an den der Regeneratoreingang über einen Eingangskondensator angeschlossen ist.

In der Fig. 3 ist ein Schnitt durch den Rohrkörper RK und dazu das Profil des Wellenwiderstandes WW entlang des Rohrkörpers dargestellt. Der freie Innendurchmesser des Rohrkörpers entspricht dem Außendurchmesser des abisolierten Anschlußkabels, so daß dessen Abschirmgeflecht die Innenmetallisierung IM des Rohrkörpers großflächig berührt, außerdem ist an der einen Seite entsprechend dem Punkte P1 das Abschirmgeflecht des Koaxialkabels und die Innenmetallisierung des Rohrkörpers gutleitend verbunden. Auf dem Rohrkörper sind zwei Ferritringe FR1, FR2 aufgeschoben, an den davon freien Umfangsflächen des Rohrkörpers ist dieser mit einer Außenmtallisierung AM versehen. Über den Umfang des Rohrkörpers ist ein Gehäuse L2a gestülpt, das mit den jeweiligen Außenmetallisierungsflächen leitend verbunden ist. Unter dem Rohrkörper ist der Verlauf des Wellenwiderstandes WW dargestellt, wobei sich deutlich die einzelnen Abschnitte A, B, C, D, E abzeichnen. Es zeigt sich, daß an den mit einer Außenmetallisierung versehenen Umfangsflächen des Rohrkörpers A, C, E der Wellenwiderstand auf einen sehr niedrigen Wert von etwa 0,5 Ω absinkt, während er an den von den Ferritringen umgebenen Umfangsflächen B und D über den Wellenwiderstand des Koaxialkabels von etwa 75 Ω auf einen Wellenwiderstand von etwa 100 Ω ansteigt. Zur Erreichung einer optimalen Dämpfung für die Störspannungen ist es nicht notwendig, die Länge L1 der metallisierten Abschnitte und der von den Ferritringen umgebenden Abschnitte L2 gleich groß zu wählen; eine Veränderung des jeweiligen Wellenwiderstandes sowie der Dämpfung in den Abschnitten B und D ist durch Verwendung eines anderen Ferrits möglich, eine weitere Veränderung ist durch Verwendung eines anderen Rohrkörpers mit anderer Dielektrizitätskonstante und anderem Verlustfaktor möglich. Die Längen L1 und L2 der einzelnen Abschnitte liegen bei 6 bis 8 mm, so daß sich eine Gesamtlänge des Rohrkörpers von etwa 40 mm ergibt. Mit den Berechnungen übereinstimmende Messungen ergaben für das Ausführungsbeispiel stark bedämpfte Resonanzfrequenzen von etwa 400 und etwa 800 MHz entsprechend den niederohmigen bzw. den hochohmigen Rohrkörperabschnitten. Die Länge L1 eines einzelnen Metallisierungsabschnitts wurde dabei im Hinblick auf die sich ergebende Resonanzfrequenz gewählt. Diese sollte in einen Frequenzbereich fallen, in dem das Übertragungssignal nur einen geringen Energieanteil hat. Die Gesamtlänge der äußeren Metallisierung als Summe der Längen L1 bestimmt die untere Grenzfrequenz der Frequenzweiche durch die bei niedrigen Frequenzen sich ergebende Summenkapazität und durch die wirksamen Induktivitäten insbesondere der Abschnitte L2. Die sich durch die Gesamtlänge der äußeren Metallisierung ergebende untere Grenzfrequenz der Frequenzweiche entspricht der unteren Grenzfrequenz der zu übertragenden digitalen Signale. Die Länge L2 des von der äußeren Metallisierung freien Abschnitts, die etwa der Höhe des an dieser Stelle aufgeschobenen Ferritringes entspricht, wurde so gewählt, daß die sich ergebende Resonanzfrequenz bei ca. 800 MHz liegt, also beim doppelten Wert der Resonanzfrequenz der niederohmigen Abschnitte.

**Patentansprüche**

1. Frequenzweiche zur Trennung eines Signalstromes und eines Versorgungsstromes (Iv), zum Einsatz in ferngespeisten Zwischenregeneratoren (R) oder Verstärkern breitbandiger Übertragungssysteme mit Koaxialkabelstrecken, die eine hohe Umlaufdämpfung bei hohen Frequenzen aufweist, mit einer eingangs- und/oder ausgangsseitigen Drosselanordnung (Le; La) für die Stromversorgung und einen Kondensator (Ck), der einen der beiden Stromversorgungsanschlüsse des Regenerators (R) bzw. Verstärkers mit dessen Bezugspotential verbindet, dadurch gekennzeichnet, daß eine homogene Leitung (L1) mit einem Wellenwiderstand entsprechend dem des Anschlußkabels (EK) vorgesehen ist, die auf der einen Seite mit Innen- und Außenleiter (L1i, L1a) mit den entsprechenden Leitern des Anschlußkabels (EK) verbunden ist, und deren Innenleiter (L1i) auf der anderen Seite mit einem Signalanschluß des Regenerators (R) bzw. Verstärkers, gegebenenfalls über einen Kondensator (Ce), verbunden ist, daß der Außenleiter (L1a) der homogenen Leitung an der Verbindungsstelle mit dem Anschlußkabel möglichst niederohmig und an seinem anderen Ende wenigstens kapazitiv mit dem Innenleiter (L2i) einer inhomogenen Leitung (L2) verbunden ist, daß in der inhomogenen Leitung Abschnitte (A, B, C, D, E . . .) gegenüber den Anschlußkabeln sehr niedrigen oder hohen Wellenwiderstandes (WW) abwechseln, daß der dem Anschlußkabel benachbarte Anschluß des Außenleiters (L2a) der inhomogenen Leitung mit einer Abschirmung in leitender Verbindung steht und daß der andere Anschluß des Außenleiters mit dem Bezugspotential des Regenerators bzw. Verstärkers verbunden ist.

2. Frequenzweiche nach Patentanspruch 1, dadurch gekennzeichnet, daß die homogene Leitung (L1) durch einen Teil des Anschlußkabels gebildet ist.

3. Frequenzweiche nach Anspruch 1, dadurch gekennzeichnet, daß die homogene Leitung (L1) durch eine Streifenleiteranordnung gebildet ist.

4. Frequenzweiche nach Patentansprüchen 1 oder 2, dadurch gekennzeichnet, daß die inhomogene Leitung durch einen hochspannungsfesten Rohrkörper (RK) gebildet ist, durch den die homogene Leitung geführt ist, daß der Rohrkörper aus einem Material hoher Dielektrizitätskonstante geformt ist, daß der Rohrkörper (RK) innen eine durchgehende Metallisierung (IM) aufweist, die den Innenleiter (L2i) der inhomogenen Leitung darstellt, daß der Rohrkörper eine äußere Metallisierung (AM) aufweist, die durch wenigstens einen Ferritring (FR1, FR2) unterbrochen ist und die den Außenleiter der niederohmigen Abschnitte der inhomogenen Leitung darstellt und daß ein mit dem Außenleiter der niederohmigen Abschnitte in leitender Verbindung stehendes, den Rohrkörper umfangsmäßig für wenigstens einen Teil seiner Länge umschließendes Abschirmgehäuse vorgesehen ist, das den Außenleiter der hochohmigen Abschnitte der inhomogenen Leitung darstellt.

5. Frequenzweiche nach einem der Patentansprüche 1 bis 4, dadurch gekennzeichnet, daß zusätzlich wenigstens eine unmittelbar mit dem Anschlußkabel verbundene Leitungsdrossel vorgesehen ist.

6. Frequenzweiche nach Patentanspruch 5, dadurch gekennzeichnet, daß die Leitungsdrossel durch einen zusätzlichen Ferritring gebildet ist, der dem Rohrkörper unmittelbar benachbart über einen freien Teil des Anschlußkabels an der dem Regenerator bzw. Verstärker abgewandten Seite aufgeschoben ist.

7. Frequenzweiche nach Patentanspruch 1, dadurch gekennzeichnet, daß das Bezugspotential des Regenerators bzw. Verstärkers mit dem Bezugspotential des Anschlußkabels über einen auf eine vorgewählte Frequenz abgestimmten Serienresonanzkreis verbunden ist.

8. Frequenzweiche nach Patentanspruch 4, dadurch gekennzeichnet, daß die Länge (L1) jeweils eines Abschnittes der äußeren Metallisierung so gewählt ist, daß die sich ergebende Resonanzfrequenz in einem Frequenzbereich auftritt, in dem das Übertragungssignal vergleichsweise geringe Energie aufweist.

9. Frequenzweiche nach Patentanspruch 4, dadurch gekennzeichnet, daß die Gesamtlänge der äußeren Metallisierung so gewählt ist, daß die bei niedrigen Frequenzen sich ergebende Summenkapazität der niederohmigen Abschnitte der inhomogenen Leitung zusammen mit den wirksamen Induktivitäten eine untere Grenzfrequenz der Frequenzweiche entsprechend der unteren Grenzfrequenz der zu übertragenden Signale ergibt.

10. Frequenzweiche nach Patentanspruch 4, dadurch gekennzeichnet, daß die Länge (L2) jeweils eines der von einem Ferritring unterbrochenen Abschnitte der äußeren Metallisierung so gewählt ist, daß die sich ergebende Resonanzfrequenz um etwa einen Faktor 2 höher als die durch die Länge (L1) bestimmten Resonanzfrequenz ist.

## Claims

1. A cross-over network for separating a signal flow and a supply current (Iv) for use in remotefed intermediate regenerators (R) or amplifiers in wide-band transmission systems, having coaxial cable links, possessing a high circulation attenuation at high frequencies, and with an input and/or output choke arrangement (Le; La) for the current supply and a capacitor (Ck) which connects one of the two current supply terminals of the regenerator (R) or amplifier to the reference potential thereof, characterised in that a homogeneous line (L1) is provided having a surge impedance corresponding to that of the connecting cable (EK), which line is connected to one side by inner and outer conductors (L1i, L1a) to the corresponding conductors of the connecting cable (EK), and whose inner conductor (L1i) is connected on the other side to a signal terminal of the regenerator (R) or amplifier, possibly via a capacitor (Ce), that the outer conductor (L1a) of the homogeneous line is so connected to the connecting cable at the connection point to prevent as low an impedance as possible, and at its other end at least capacitively to the inner conductor (L2i) of an inhomogeneous line (L2), that in the inhomogeneous line alternate sections (A, B, C, D, E . . .) have a very low or very high surge impedance (WW) in relation to the connecting cable, that that terminal of the outer conductor (L2a) of the inhomogeneous line which is adjacent to the connecting cable is conductively connected to a screen, and that the other terminal of the outer conductor is connected to the reference potential of the regenerator or amplifier, as the case may be.

2. A cross-over network as claimed in claim 1, characterised in that the homogeneous line (L1) is formed by a part of the connecting cable.

3. A cross-over network as claimed in claim 1, characterised in that the homogeneous line (L1) is formed by a strip conductor arrangement.

4. A cross-over network as claimed in claims 1 or 2, characterised in that the inhomogeneous line is formed by a highvoltage-resistant tubular body (RK) through which the homogeneous line is conducted, that the tubular body consists of a material which possesses a high dielectric constant, that the tubular body (RK) is internally provided with a through-going metallisation (IM) which represents the inner conductor (L21) of the inhomogeneous line, that the tubular body possesses an outer metallisation (AM) which is interrupted by at least one ferrite ring (FR1, FR2) to represent the outer conductor of the low-value sections of the inhomogeneous line, and that screening housing is provided which is conductively connected to the outer conductor of the low-value sections and which peripherally surrounds the tubular body for at least a part of its length and which represents the outer conductor of the high-value sections of the inhomogeneous line.

5. A cross-over network as claimed in one of claims 1 to 4, characterised in that there is at least one additional line choke directly connected to the connecting cable.

6. A cross-over network as claimed in claim 5, characterised in that the line choke is formed by an additional ferrite ring which, directly adjacent to the tubular body, is placed over a free part of the connecting cable on the side remote from the regenerator or amplifier, as the case may be.

7. A cross-over network as claimed in claim 1, characterised in that the reference potential of the regenerator or amplifier is connected to the reference potential of the connecting cable via a series resonant circuit which is tuned to a preselected frequency.

8. A cross-over network as claimed in claim 4, characterised in that the length (L1) of each section of the outer metallisation is selected to be such that the resultant resonant frequency occurs in a frequency range in which the transmission signal possesses a comparatively low level of energy.

9. A cross-over network as claimed in claim 4, characterised in that the overall length of the outer metallisation is selected to be such that the sum capacity of the low-value sections of the inhomogeneous line at low frequencies, together with the active inductances, results in a low cut-off frequency of the network in accordance with the low cut-off frequency of the signals which are to be transmitted.

10. A cross-over network as claimed in claim 4, characterised in that the length (L2) of each of the sections of the outer metallisation which are interrupted by a ferrite ring is selected to be such that the resultant resonant frequency exceeds the resonant frequency determined by the length (L1) by a factor of approximately 2.

## Revendications

1. Filtre d'aiguillage utilisé pour la séparation d'un courant de signal et d'un courant d'alimentation (Iv), destiné à être utilisé dans des régénérateurs intermédiaires (R) ou des amplificateurs, alimentés à distance, le système de transmission à large bande comportant des sections de câble coaxial, et qui présente un affaiblissement élevé de circulation pour des fréquences élevées et comporte un ensemble à bobine d'arrêt (Le, La) situé du côté entrée et/ou du côté sortie, pour l'alimentation en courant, et un condensateur (Ck) qui relie l'une des deux bornes d'alimentation en courant du régénérateur (R) ou de l'amplificateur au potentiel de référence de ce dernier, caractérisé par le fait qu'il est prévu une ligne homogène (L1) possédant une impédance caractéristique correspondant à celle du câble de raccordement (EK) et qui est reliée, d'un côté, par un conducteur intérieur et par un conducteur extérieur (L1i, L1a) aux conducteurs correspondants du câble de raccordement (EK), et dont le conducteur intérieur (L1i) est relié, de l'autre côté, à une borne de transmission de signaux du régénérateur (R) ou de l'amplificateur, éventuellement par l'intermédiaire d'un condensateur (Ce), que le conducteur extérieur (L1a) de la ligne homogène est relié, selon une liaison d'une valeur ohmique aussi faible que possible, au niveau du point de jonction avec le câble de raccordement et est relié, à son autre extrémité, de manière au moins capacitive, au conducteur intérieur (L2i) d'une ligne hétérogène (L2), que dans la ligne hétérogène, des sections (A, B, C, D, E ...) possédant une impédance caractéristique très faible ou très élevée par rapport aux câbles de raccordement alternent entre elles, que la borne, voisine du câble de raccordement, du conducteur extérieur (L2i) de la ligne hétérogène est reliée de façon conductrice à un blindage et que l'autre borne du conducteur extérieur est reliée au potentiel de référence du régénérateur ou de l'amplificateur.

2. Filtre d'aiguillage suivant la revendication 1, caractérisé par le fait que la ligne hétérogène (L1) est formée par une partie du câble de raccordement.

3. Filtre d'aiguillage suivant la revendication 1, caractérisé par le fait que la ligne homogène (L1) est formée par un ensemble de conducteurs en forme de bandes.

4. Filtre d'aiguillage suivant les revendications 1 ou 2, caractérisé par le fait que la ligne hétérogène est formée par un corps tubulaire (RK) résistant à la haute tension, à l'intérieur duquel s'étend une ligne hétérogène, que le corps tubulaire est formé à partir d'un matériau possédant une constante diélectrique élevée, que le corps tubulaire (RK) possède en son intérieur une métallisation continue (IM), qui représente le conducteur intérieur (L2i) de la ligne hétérogène, que le corps tubulaire comporte une métallisation extérieure (AM), qui est interrompue par au moins un anneau de ferrite (FR1, FR2) et qui représente le conducteur extérieur des sections de faible valeur ohmique de la ligne hétérogène, et qu'il est prévu un logment formant blindage relié de façon conductrice au conducteur extérieur des sections de faible valeur ohmique et entourant circonférentiellement le corps tubulaire sur au moins une partie de sa longueur, et représentant le conducteur extérieur des sections de forte valeur ohmique de la ligne hétérogène.

5. Filtre d'aiguillage suivant les revendications 1 à 4, caractérisé par le fait qu'il est prévu en supplément au moins une bobine d'arrêt de ligne reliée directement au câble de raccordement.

6. Filtre d'aiguillage suivant la revendication 5, caractérisé par le fait que la bobine d'arrêt de ligne est formée par un anneau de ferrite supplémentaire, qui est emmanché sur le corps tubulaire, au voisinage immédiat et au-dessus d'une partie libre du câble de raccordement, sur le côté situé à l'opposé du régénérateur ou de l'amplificateur.

7. Filtre d'aiguillage suivant la revendication 1, caractérisé par le fait que le potentiel de référence du régénérateur ou de l'amplificateur est relié au potentiel de référence du câble de raccordement par l'intermédiaire d'un circuit résonnant série accordé sur une fréquence présélectionnée.

8. Filtre d'aiguillage suivant la revendication 4, caractérisé par le fait que la longueur (L) d'une section respective de la métallisation extérieure est choisie de manière que la fréquence de résonance obtenue apparaisse dans une plage de fréquences, dans laquelle le signal de transmission possède une énergie comparativement faible.

9. Filtre d'aiguillage suivant la revendication 4, caractérisé par le fait que la longueur totale de la métallisation extérieure est choisie de telle manière que la capacité totale, obtenue pour les basses fréquences, des sections de faible valeur ohmique de la ligne hétérogène fournit, avec les inductances actives, une fréquence limite inférieure du filtre d'aiguillage, qui correspond à la fréquence limite inférieure des signaux devant être transmis.

10. Filtre d'aiguillage suivant la revendication 4, caractérisé par le fait que la longueur (L2) de chacune des sections de la métallisation extérieure interrompues par un anneau de ferrite, est choisie de manière que la fréquence de résonance obtenue soit supérieure, approximativement du facteur 2, à la fréquence de résonance déterminée par la longueur (L1).

# FIG 1

S

EK

L1i

L1a

P1

P2

L2i

Ce

Le

Iv

R

Rv

Ca

La

P3

L3i

L3a

AK

A B C D E

L2a

Ck

L4i

L4a

# FIG 2

K

FP

KK

G1

FR3

RK

FR2

L2a

FR1

G2

L1a

L1i

Js

# FIG 3

FR2

FR1

RK

L2a

AM

IM

L2

L1

WW

L

A    B    C    D    E